# EUROPÄISCHE PATENTSCHRIFT

(11) **EP 1 402 583 B1**
(45) Veröffentlichungstag und Bekanntmachung des Hinweises auf die Patenterteilung: **31.08.2005**
(21) Anmeldenummer: 02750788.8
(22) Anmeldetag: 14.06.2002
(51) Int. Cl.: H01L 41/09

(54) **PIEZOELEKTRISCHER BIEGEWANDLER**
PIEZOELECTRICAL BENDING CONVERTER
TRANSDUCTEUR PIEZOELECTRIQUE DE FLEXION

(30) Priorität: 27.06.2001 DE 10130895
(43) Veröffentlichungstag der Anmeldung: 31.03.2004
(73) Patentinhaber: SIEMENS AKTIENGESELLSCHAFT, 80333 München (DE)
(72) Erfinder: SCHUH, Carsten, 85598 Baldham (DE); STEINKOPFF, Thorsten, 85614 Eglharting (DE); WOLFF, Andreas, 81825 München (DE)
(86) Internationale Anmeldenummer: PCT/DE2002/002183
(87) Internationale Veröffentlichungsnummer: WO 2003/003478

(56) Entgegenhaltungen:
- EP-A- 0 784 349
- EP-A- 0 993 055
- DD-A- 287 813
- DD-A- 293 918
- DE-A- 3 142 684
- DE-A- 4 218 368
- PATENT ABSTRACTS OF JAPAN vol. 1998, no. 03, 27. Februar 1998 (1998-02-27) & JP 09 289342 A (SONY CORP), 4. November 1997 (1997-11-04) -& JP 09 289342 A (SONY CORP) 4. November 1997 (1997-11-04)
- PATENT ABSTRACTS OF JAPAN vol. 1998, no. 10, 31. August 1998 (1998-08-31) & JP 10 144976 A (DENSO CORP), 29. Mai 1998 (1998-05-29) -& JP 10 144976 A (DENSO CORP) 29. Mai 1998 (1998-05-29)

## Beschreibung

Die Erfindung betrifft einen piezoelektrischen Biegewandler mit mindestens einem monolithischen Schichtverbund, aufweisend eine piezoelektrisch aktive Keramikschicht mit einer durch ein elektrisches Feld erzeugbaren lateralen Abmessungsänderung und mindestens eine weitere piezoelektrisch aktive Keramikschicht mit einer durch ein weiteres elektrisches Feld erzeugbaren, von der lateralen Abmessungsänderung verschiedenen weiteren lateralen Abmessungsänderung. Zur Erzeugung der elektrischen Felder ist zwischen den Keramikschichten mindestens eine Elektrodenschicht angeordnet.

Ein derartiger Biegewandler ist beispielsweise aus EP 0 784 349 A1 bekannt, bei dem die piezoelektrisch aktiven Keramikschichten unterschiedliche Schichtdicken aufweisen und so bei gleichen Feldstärken unterschiedliche Abmessungsänderungen hervorgerufen werden. Biegewandler mit piezoelektrisch aktiven Schichten unterschiedlicher Schichtdicken sind auch aus EP 0 993 055 A2 und JP 09 289342 A bekannt. Die bekannten Biegewandler sind streifenförmig und werden im Betrieb eingespannt.

Ein dazu alternativer Biegewandler ist aus Xiaoping L. et al., J. Am. Ceram. Soc., 84 (5), 996 - 1003 (2001) bekannt. Die piezoelektrisch aktiven Keramikschichten des monolithischen Schichtverbundes des bekannten Biegewandlers sind aus unterschiedlichem Bleizirkonattitanat (PZT). Die Keramikschichten weisen unterschiedliche d₃₁-Koeffizienten auf. Unter dem Einfluss eines elektrischen Feldes kommt es jeweils zu einer Abmessungsänderung (Verkürzung) der betreffenden Keramikschicht entlang einer flächenhaften (lateralen) Ausdehnung der Keramikschicht. Der d₃₁-Koeffizient ist ein Maß für die erzeugbare Abmessungsänderung und hängt beispielsweise vom Keramikmaterial, von der schichtdicke und der Polarisation der Keramikschicht ab.

Im Schichtverbund ist kein Sprung der d₃₁-Koeffizienten zwischen den Keramikschichten in Stapelrichtung des Schichtverbundes vorhanden. Vielmehr ändert sich der d₃₁-Koeffizient stetig in der Stapelrichtung. Es ist ein Gradient des d₃₁-Koeffizienten in Stapelrichtung vorhanden.

Durch die unterschiedlichen d₃₁-Koeffizienten der Keramikschichten beziehungsweise durch den Gradienten des d₃₁-Koeffizienten kommt es bei annähernd gleichen elektrischen Feldern, denen die Keramikschichten ausgesetzt werden, zu einer Verformung (Verbiegung) des Schichtverbundes. Es tritt ein Hub in Stapelrichtung des Schichtverbundes auf.

Die tatsächliche Abmessungsänderung jeder Keramikschicht und damit ein Ausmaß der Verbiegung beziehungsweise des Hubes des Schichtverbundes hängt von einer Stärke des elektrischen Feldes ab, das in der Keramikschicht wirkt. Zur Erzeugung der elektrischen Felder weist der monolithische Schichtverbund zwei Elektrodenschichten auf, zwischen denen die beiden piezoelektrisch aktiven Keramikschichten angeordnet sind. Die elektrischen Felder in den Keramikschichten können nicht unabhängig voneinander erzeugt werden. Das Erzeugen eines bestimmten Hubes des Schichtverbundes ist daher relativ schwierig.

Aus A. Dogan et al., IEEE Trans. Ultrason., Ferroelectr., Freq. Contr., Vol 44, No. 3, 597 - 605, 1997 sind Biegewandler vom Typ "Bimorph", "Cymbal", "Moonie", "Multilayer" und "Rainbow" bekannt. Zur Erhöhung eines effektiven Hubs können mehrere Biegewandler eines der Typen zu einem Stapel angeordnet sein. Dabei trägt jeder einzelne Biegewandler des Stapels mit seiner Verbiegung beziehungsweise mit seinem Hub zum effektiven Hub des Stapels bei. Die Biegewandler der genannten Typen weisen zur Huberzeugung jeweils einen Schichtverbund aus mindestens einer piezoelektrisch aktiven und mindestens einer piezoelektrisch inaktiven Schicht auf. Zur Erzeugung der Verbiegung wird an einer Grenzfläche zwischen den Schichten ein deutlicher Spannungssprung erzeugt. Der deutliche Spannungssprung reduziert aber eine Zuverlässigkeit des Biegewandlers. Bei ständiger Beanspruchung des Biegewandlers kann es leicht zum Ausfall des Biegewandlers kommen.

Aus DD 287 813 A5 ist ein Stapel aus Paaren von gleichartigen Biegewandlern bekannt. Durch das Stapeln wird eine erhöhte Auslenkung erzielt.

Aufgabe der vorliegenden Erfindung ist es, einen zuverlässigen piezoelektrischen Biegewandler anzugeben, dessen Hub im Vergleich zum bekannten Stand der Technik relativ leicht eingestellt werden kann.

Zur Lösung der Aufgabe wird ein piezoelektrischer Biegewandler mit mindestens einem monolithischen Schichtverbund angegeben, aufweisend eine piezoelektrisch aktive Keramikschicht mit einer durch ein elektrisches Feld erzeugbaren lateralen Abmessungsänderung und mindestens eine weitere piezoelektrisch aktive Keramikschicht mit einer durch ein weiteres elektrisches Feld erzeugbaren, von der lateralen Abmessungsänderung verschiedenen weiteren lateralen Abmessungsänderung, wobei zur Erzeugung der elektrischen Felder zwischen den Keramikschichten mindestens eine Elektrodenschicht angeordnet ist. Der piezoelektrische Biegewandler ist dadurch gekennzeichnet, dass der Schichtverbund selbsttragend ist und eine runde Grundfläche aufweist.

Beispielsweise besteht der monolithische Schichtverbund aus mehreren piezoelektrisch aktiven Keramikschichten und dazwischen angeordneten inneren Elektrodenschichten. Jede der inneren Elektrodenschichten dient der Erzeugung der elektrischen Felder in den benachbarten piezoelektrisch aktiven Keramikschichten. Jede der piezoelektrisch aktiven Keramikschichten ist in Dickenrichtung der Keramikschicht und damit in Stapelrichtung des monolithischen Schichtverbundes polarisiert. Beim Polarisieren werden bei Anlegen alternierender Polaritäten an benachbarten Elektrodenschichten in benachbarten Keramikschichten entgegengesetzte Polarisationsrichtungen erzeugt. Durch die elektrische Ansteuerung der Elektrodenschichten im Betrieb des Biegewandlers, d.h. durch Erzeugen elektrischer Felder parallel zur den Polarisationsrichtungen, kommt es zu den lateralen Abmessungsänderung entlang der Keramikschichten. Die Keramikschichten werden senkrecht zu den Polarisationsrichtungen und damit zur den Dickenrichtungen der Keramikschichten verkürzt.

Denkbar ist auch, dass zwischen benachbarten piezoelektrisch aktiven Keramikschichten zwei voneinander elektrisch isolierte Elektrodenschichten angeordnet sind. Damit ließen sich gleich gerichtete Polarisationsrichtungen in den benachbarten Keramikschichten induzieren.

Monolithisch bedeutet, dass der Schichtverbund durch gemeinsames Sintern (co-firing) der Keramikschichten und der dazwischen angeordneten Elektrodenschichten hergestellt wird. Beispielsweise werden zum Herstellen des monolithischen Schichtverbundes mehrere, mit Elektrodenmaterial bedruckte keramische Grünfolien übereinander gestapelt, laminiert, gegebenenfalls entbindert und nachfolgend gesintert. Die Grünfolien sind beispielsweise so gewählt, dass durch das Sintern Schichtdicken der Keramikschichten aus dem Bereich zwischen 20 µm und 500 µm resultieren.

Der grundlegende Gedanke der Erfindung besteht darin, zur Erzeugung einer Verbiegung beziehungsweise eines Hubes des Biegewandlers nur piezoelektrisch aktive Keramikschichten zu benutzen. Die Erzeugung des Hubes gelingt ohne piezoelektrisch inaktive Schicht. Dazu sind die in den Keramikschichten erzeugbaren lateralen Abmessungsänderungen unterschiedlich. Um eine möglichst gute Abstimmung der Abmessungsänderungen zu erhalten, ist jeweils zwischen zwei piezoelektrisch aktiven Keramikschichten eine Elektrodenschicht vorhanden. Die Elektrodenschicht ist im Vergleich zu den Keramikschichten sehr dünn und fungiert daher nicht als piezoelektrisch inaktive Schichten im oben genannten Sinn. Mit Hilfe der Elektrodenschicht wird jeweils eine bestimmte Polarisation der benachbarten Keramikschichten erzeugt. Zudem dient die Elektrodenschicht der Erzeugung der für die Abmessungsänderungen benötigten elektrischen Felder. Sowohl die Polarisationen als auch die elektrischen Felder beziehungsweise die Stärken der elektrischen Felder können im Vergleich zum bekannten Stand der Technik leichter und genauer eingestellt werden. Dies liegt beispielsweise daran, dass durch die Elektrodenschicht eine Wahrscheinlichkeit für eine während des gemeinsamen Sinterns erzeugte Mischphase oder Pore zwischen benachbarten Keramikschichten deutlich reduziert ist. Derartige Mischphasen oder Poren beeinflussen in unvorhersehbarer Weise die Polarisation einer Keramikschicht und ebenso das elektrische Feld, dem die Keramikschicht im Betrieb ausgesetzt wird.

In einer besonderen Ausgestaltung ist in einer Stapelrichtung des Schichtverbundes ein Gradient der lateralen Abmessungsänderungen der Keramikschichten erzeugbar. Dies bedeutet, dass sich im Betrieb des Biegewandlers das Ausmaß der Abmessungsänderungen von Keramikschicht zu Keramikschicht in Stapelrichtung des Schichtverbundes sukzessive in eine Richtung ändert. Beispielsweise besteht der Schichtverbund aus drei piezoelektrisch aktiven Keramikschichten. Im Betrieb verkleinert sich das Ausmaß der Verkürzung der drei Keramikschichten von Keramikschicht zu Keramikschicht. Die Abmessungsänderungen ändern sich von Keramikschicht zu Keramikschicht sprunghaft. Die Abmessungsänderungen werden aber vorzugsweise so eingestellt, dass auftretende Spannungssprünge zwischen benachbarten Keramikschichten deutlich kleiner sind als im Verbund einer piezoelektrisch aktiven und piezoelektrisch inaktiven Schicht.

Zur Erzielung der unterschiedlichen lateralen Abmessungsänderungen gibt es verschiedene Möglichkeiten. Beispielsweise weisen die Keramikschichten unterschiedliche d₃₁-Koeffizienten auf, wobei zur Erzielung der Verbiegung des Schichtverbundes die im Betrieb auf die Keramikschichten einwirkenden elektrischen Felder gleich sein könnten. Denkbar ist auch, dass die d₃₁-Koeffizienten gleich, dafür aber die elektrischen Felder unterschiedlich sind.

Der d₃₁-Koeffizient hängt vom Keramikmaterial der Keramikschichten ab. In einer besonderen Ausgestaltung weisen die Keramikschichten ein-gleiches Keramikmaterial auf. Dies hat beispielsweise den Vorteil, dass (bei hinreichend gleicher Polarisation der Keramikschichten) nahezu keine Biegung aufgrund eines unterschiedlichen thermischen Ausdehnungskoeffizienten unterschiedlichen Keramikmaterials auftritt. Es kommt zu keiner thermisch induzierten Verbiegung. Denkbar ist aber auch, dass die Keramikschichten unterschiedliches Keramikmaterial aufweisen. Vorteilhaft ist dabei, wenn die thermische Ausdehnungskoeffizienten der Keramikmaterialien ähnlich sind.

In einer weiteren Ausgestaltung weisen die Keramikschichten im Wesentlichen gleiche Schichtdicken auf. Im Wesentlichen gleich bedeutet, dass eine Toleranz von bis zu 10% zulässig ist. Wenn die Schichtdicken der Keramikschichten gleich sind und die Keramikschichten aus dem gleichen Keramikmaterial bestehen, kann eine unterschiedliche Abmessungsänderung dadurch erzeugt werden, dass bei gleicher Polarisation unterschiedliche elektrische Feldstärken auf die Keramikschichten einwirken. Unterschiedliche Abmessungsänderungen sind auch dadurch zugänglich, dass die Keramikschichten unterschiedliche Polarisationen aufweisen und gleichen oder ähnlichen elektrischen Feldstärken ausgesetzt werden. Die Feldstärken werden dabei vorteilhaft so gewählt, dass es im Betrieb des Biegewandlers zu keiner Änderung der Polarisation der Keramikschichten kommt (Nachpolung).

In einer besonderen Ausgestaltung weisen die Keramikschichten unterschiedliche Schichtdicken auf. Sowohl beim Polarisieren der Keramikschichten als auch im Betrieb des Biegewandlers können die Elektrodenschichten bei alternierender Beschaltung mit den gleichen elektrischen Potentialen beaufschlagt werden. Dies führt dazu, dass bei gleicher elektrischer Ansteuerung der Elektrodenschichten unterschiedliche Abmessungsänderungen der Keramikschichten hervorgerufen werden können.

In einer weiteren Ausgestaltung weist der Schichtverbund mindestens ein Mittel zur Reduzierung einer Eigensteifigkeit des Schichtverbundes auf. Durch die Reduzierung der Eigensteifigkeit kann ein erhöhter Hub des Schichtverbundes erreicht werden. Insbesondere ist das Mittel zur Reduzierung der Eigensteifigkeit ein Loch. Das Loch ist im Schichtverbund derart angeordnet, dass bei dem Schichtverbund mit Loch für einen bestimmten Hub weniger Energie nötig ist als bei einem entsprechenden Schichtverbund ohne Loch. Das Loch ist beispielsweise eine Bohrung oder eine Durchbohrung des Schichtverbundes in Stapelrichtung.

Der Schichtverbund stellt einen Kreisscheibenbieger dar. Jede der Keramikschichten ist dabei vorzugsweise eine Scheibe. Bei einer Polarisation einer scheibenförmigen Keramikschicht in Dickenrichtung tritt der d₃₁-Koeffizient radial und in Umfangsrichtung der Keramikschicht auf. Der Umfang der Keramikschicht verkleinert sich durch das Einwirken eines elektrischen Feldes parallel zur Polarisationsrichtung. Der d₃₁-Koeffizient wird in günstiger Weise vom d₃₃-Koeffizient überlagert, der zu einer Vergrößerung der Schichtdicke führt. Es kommt zu einer Verschiebung in axialer Richtung. Der resultierende Hub der Keramikschicht ist erhöht.

Zudem zeichnet sich der Kreisscheibenbieger durch eine gute Stabilität aus. Der Kreisscheibenbieger ist selbsttragend. Eine Auflage des Kreisscheibenbiegers ist beispielsweise nicht punktförmig, sondern erstreckt sich über den Umfang des Kreisscheibenbiegers. Ein weiterer Vorteil besteht darin, dass der Kreisscheibenbieger nur fixiert werden muss. Er muss, beispielsweise im Gegensatz zu einem Biegewandler in Streifenform, nicht eingespannt werden. Bei einer hohen Steifigkeit einer Einspannung des Biegewandlers kann es beispielsweise zu einer mechanischen Schädigung des Biegewandlers im Einspannbereich kommen. Ein derartiges Problem tritt beim Kreisscheibenbieger nicht auf. Als weitere Vorteile sind eine im Vergleich zu anderen Bauformen erhöhte Blockierkraft, eine erhöhte Steifigkeit und eine relativ hohe Resonanzfrequenz zu nennen. Zudem kann zur Herstellung des Kreisscheibenbiegers auf bewährte Verfahren zur Herstellung von keramischen Mehrschicht-Aktoren zurückgegriffen werden.

In einer besonderen Ausgestaltung sind mehrere monolithische Schichtverbünde zu einem Stapel angeordnet. Insbesondere sind mehrere Schichtverbünde in Form von Kreisscheibenbiegern zu einem Stapel angeordnet. Die Kreisscheibenbieger sind wechselseitig angeordnet, so dass ein erheblicher effektiver Hub in Folge einer additiven Überlagerung der Hübe der einzelnen Kreisscheibenbieger erreicht werden kann. Die Kreisscheibenbieger können dabei von außen über eine Hülse fixiert werden. Wenn die Kreisscheibenbieger über ein Loch verfügen, können sie auch über eine Achse, die durch die Löcher geführt ist, fixiert werden.

Zusammenfassend ergeben sich mit der Erfindung folgende wesentlichen Vorteile:
- Zur Erzielung des Hubes ist keine piezoelektrisch inaktiven Schicht nötig.
- Im Schichtverbund ist ein Gradient der Abmessungsänderungen erzeugbar, der den Hub bewirkt.
- Die zwischen den Keramikschichten auftretenden Spannungssprünge sind sehr klein. Dadurch ist die Stabilität des Biegewandlers erhöht.
- Durch die (separat ansteuerbaren) Elektrodenschichten zwischen den piezoelektrisch aktiven Keramikschichten des Schichtverbundes können die elektrischen Felder, denen die Keramikschichten im Betrieb ausgesetzt sind, frei gewählt werden.
- Die Elektrodenschichten verhindern die Bildung von Mischphasen und Poren an den Grenzflächen benachbarter Keramikschichten. Die elektrischen Felder und damit die Abmessungsänderungen lassen sich sehr gut einstellen.
- Im Mehrschichtaufbau können zur Erzielung des Hubes relativ niedrige Spannungen an den Elektrodenschichten angelegt werden.
- Ein Biegewandler mit einem Schichtverbund in Form eines Kreisscheibenbiegers ist kostengünstig herzustellen, selbsttragend und stabil. Er zeichnet sich aufgrund des Zusammenwirkens der d₃₁- und d₃₃-Koeffizienten durch einen besonders hohen Hub aus.
- Ein hoher effektiver Hub kann dadurch erzielt werden, dass mehrere Schichtverbünde, insbesondere Kreisscheibenbieger, übereinander gestapelt werden.

Im Folgenden wird anhand mehrerer Ausführungsbeispiele und der dazu gehörenden Figuren der piezoelektrische Biegewandler mit monolithischem Schichtverbund vorgestellt. Die Figuren sind schematisch und stellen keine maßstabsgetreuen Abbildungen dar.
- Figur 1: zeigt einen Schichtverbund im einem seitlichen Querschnitt.
- Figuren 2a bis 2c: zeigen die Grundflächen verschiedener Schichtverbünde.
- Figuren 3a und 3b: zeigen Stapel von Schichtverbünden bei elektrischer Ansteuerung.

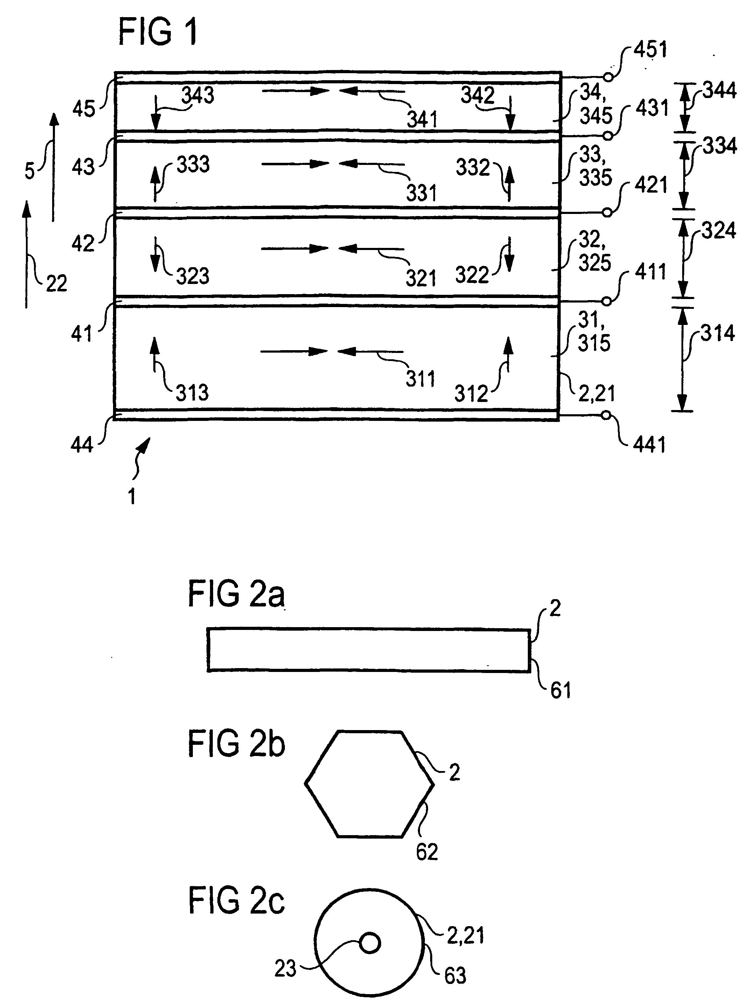

Der piezoelektrische Biegewandler 1 weist einen monolithischen Schichtverbund 2 auf (Figur 1). Der Schichtverbund 2 besteht aus vier piezoelektrisch aktiven Keramikschichten 31 bis 34. Die Keramikschichten weisen jeweils das gleiche Keramikmaterial 315 bis 345 auf. Das Keramikmaterial ist ein Bleizirkonattitanat (PZT). Die Polarisationen 313 bis 343 der Keramikschichten 31 bis 34 sind vom Betrag her ungefähr gleich. Die Polarisationen benachbarter Keramikschichten sind parallel zueinander, aber einander entgegengerichtet. Die d₃₁-Koeffizienten der Keramikschichten sich gleich und betragen etwa -350 pm/V. Die Schichtdicken der Keramikschichten 31 bis 34 sind unterschiedlich. Sie liegen zwischen 50 und 150 µm und nehmen in Stapelrichtung 22 des Schichtverbundes 2 ab. Zwischen den Keramikschichten 31 bis 34 sind innere Elektrodenschichten 41 bis 43 angeordnet. Den Abschluss in Stapelrichtung 22 des monolithischen Schichtverbundes bilden zwei äußere Elektrodenschichten 44 und 45. Die Gesamtdicke des Schichtverbundes 2 beträgt 300 µm. Der Schichtverbund 2 ist ein Kreisscheibenbieger 21 mit einer runden Grundfläche 63 mit einem Radius von etwa 5 mm (Figur 2c). Zur Reduzierung der Eigensteifigkeit weist der Kreisscheibenbieger 2 ein Loch 22 mit Radius von auf etwa 1,5 mm auf (Figur 2c). Das Loch 23 ist eine Durchbohrung des Kreisscheibenbiegers 2 in Stapelrichtung 22.

Im Betrieb des Biegwandlers 1 werden die inneren und äußeren Elektrodenschichten 41 bis 45 alternierend mit den Potentialen 411 bis 451 beaufschlagt. Die Potentiale 411 und 431 betragen 100 V und die Potentiale 441, 421 und 451 0V. Durch die Kombination von verschiedenen Schichtdicken der piezoelektrisch aktiven Keramikschichten und gleichen Potentialdifferenzen zwischen den Elektrodenschichten werden die Keramikschichten unterschiedlich starken elektrischen Feldern 312 bis 342 ausgesetzt. Es resultieren unterschiedliche Abmessungsänderungen 311 bis 314, wobei ein Gradient 5 der lateralen Abmessungsänderungen im Schichtverbund 2 beziehungsweise im Kreisscheibenbieger erzeugt wird.

Ein weiteres Ausführungsbeispiel zeichnet sich dadurch aus, dass die Schichtdicken der Keramikschichten 31 bis 34 im Wesentlichen gleich sind. Zur Erzielung unterschiedlicher lateraler Abmessungsänderungen der Keramikschichten werden zwischen den Elektrodenschichten unterschiedliche Potentialdifferenzen und dadurch unterschiedliche starke elektrische Felder erzeugt. Die Elektrodenschichten werden einzeln angesteuert.

Weiter Ausführungsbeispiele unterscheiden sich von den beschriebenen durch unterschiedliche Grundflächen des Schichtverbundes. Eine rechteckige Grundfläche 61 (Figur 2a) führt zu einem streifenförmigen Schichtverbund. Denkbar ist auch eine sechseckige Grundfläche 62, wie sie in Figur 2b angedeutet ist.

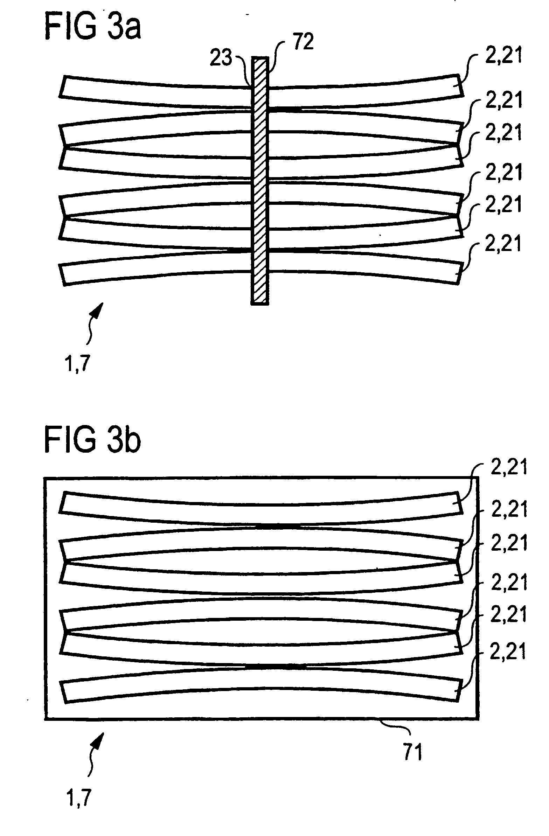

Um einen möglichst großen Hub zu erzielen werden mehrere Schichtverbünde 2 in Form des Kreisscheibenbiegern 21 zu einem Stapel 7 angeordnet. Die Kreisscheibenbieger 21 sind wechselseitig gestapelt. Dies bedeutet, dass die elektrische Ansteuerung der Kreisscheibenbieger 21 zu einer additiven Überlagerung der in den einzelnen Kreisscheibenbiegern erzeugten Hübe zu einem effektiven Gesamthub führt. Zur Fixierung dient in einer Ausführungsform eine Achse 72, die durch die Durchbohrungen 23 der gestapelten Kreisscheibenbieger 21 führt (Figur 3a). Alternativ dazu ist der Stapel 7 in einer entsprechend dimensionierten Hülse 71 angeordnet (Figur 3b).

## Patentansprüche

1. Piezoelektrischer Biegewandler (1) mit mindestens einem monolithischen Schichtverbund (2, 21), aufweisend
- eine piezoelektrisch aktive Keramikschicht (31) mit einer durch ein elektrisches Feld (312) erzeugbaren lateralen Abmessungsänderung (311) und
- mindestens eine weitere piezoelektrisch aktive Keramikschicht (32) mit einer durch ein weiteres elektrisches Feld (322) erzeugbaren, von der lateralen Abmessungsänderung (311) verschiedenen weiteren lateralen- Abmessungsänderung (321), wobei
- zur Erzeugung der elektrischen Felder (312, 322) zwischen den Keramikschichten (31, 32) mindestens eine Elektrodenschicht (411) angeordnet ist,
**dadurch gekennzeichnet, dass**
- der Schichtverbund (2, 21) selbsttragend ist und
- eine runde Grundfläche (63) aufweist.

2. Biegewandler nach Anspruch 1, wobei in einer Stapelrichtung (22) des Schichtverbundes(2, 21) ein Gradient (5) der lateralen Abmessungsänderungen der Keramikschichten erzeugbar ist.

3. Biegewandler nach Anspruch 1 oder 2, wobei die Keramikschichten (31, 32) ein gleiches Keramikmaterial (315, 325) aufweisen.

4. Biegewandler nach Anspruch 1 oder 2, wobei die Keramikschichten (31, 32) unterschiedliches Keramikmaterial (315, 325) aufweisen.

5. Biegewandler nach einem der Ansprüche 1 bis 4, wobei die Keramikschichten (31, 32) im Wesentlichen gleiche Schichtdicken (314, 324) aufweisen.

6. Biegewandler nach einem der Ansprüche 1 bis 4, wobei die Keramikschichten (31, 32) unterschiedliche Schichtdicken (314, 324) aufweisen.

7. Biegewandler nach einem der Ansprüche 1 bis 6, wobei der Schichtverbund (2, 21) mindestens ein Mittel (23) zur Reduzierung einer Eigensteifigkeit des Schichtverbundes (2) aufweist.

8. Biegewandler nach Anspruch 7, wobei das Mittel (23) zur Reduzierung der Eigensteifigkeit ein Loch ist.

9. Biegewandler nach einem der Ansprüche 1 bis 8, bei dem mehrere monolithische Schichtverbünde (2, 21) zu einem Stapel (7) angeordnet sind.

## Claims

1. Piezoelectric flextensional transducer (1) with at least one monolithic multilayer system (2, 21), having
- a piezoelectrically active ceramic layer (31) with a lateral dimensional change (311) inducible by an electric field (312) and
- at least one other piezoelectrically active ceramic layer (32) with another lateral dimensional change (321) inducible by an electric field (322) and different from said lateral dimensional change (311),
in which,
- to generate the electric fields (312, 322), at least one electrode layer (411) is disposed between the ceramic layers (31, 32), **characterised in that**
- the multilayer system (2, 21) is self-supporting and has a round footprint (63).

2. Flextensional transducer according to Claim 1, wherein a gradient (5) in the lateral dimensional changes of the ceramic layers can be produced in a stacking direction (22) of the multilayer system (2, 21).

3. Flextensional transducer according to Claim 1 or 2, wherein the ceramic layers (31, 32) are of the same ceramic material (315, 325).

4. Flextensional transducer according to Claim 1 or 2, wherein the ceramic layers (31, 32) are of different ceramic material (315, 325).

5. Flextensional transducer according to one of Claims 1 to 4, wherein the ceramic layers (31, 32) have essentially identical layer thicknesses (314, 324).

6. Flextensional transducer according to one of Claims 1 to 4, wherein the ceramic layers (31, 32) have different layer thicknesses (314, 324).

7. Flextensional transducer according to one of Claims 1 to 6, wherein the multilayer system (2, 21) has at least one means (23) of reducing any intrinsic stiffness of the multilayer system (2).

8. Flextensional transducer according to Claim 7, wherein the means (23) of reducing the intrinsic stiffness is a hole.

9. Flextensional transducer according to one of Claims 1 to 8, wherein a plurality of monolithic multilayer systems (2, 21) are arranged in a stack (7).

## Revendications

1. Transducteur piézoélectrique de flexion (1) avec au moins un composite monolithique en couches (2, 21) comportant :
- une couche céramique piézoélectriquement active (31) avec une variation de dimension latérale (311) pouvant être produite par un champ électrique (312)
- et au moins une autre couche céramique piézoélectriquement active (32) avec une autre variation de dimension latérale (321) différente de la variation de dimension latérale (311) et pouvant être produite par un autre champ électrique (322),
- au moins une couche d'électrodes (411) étant placée entre les couches céramiques (31, 32) pour produire les champs électriques (312, 322),
**caractérisé en ce que**
- le composite en couches (2, 21) est autoporteur
- et comporte une surface de base (63) ronde.

2. Transducteur de flexion selon la revendication 1, dans lequel un gradient (5) des variations de dimension latérale des couches céramiques peut être produit dans une direction d'empilement (22) du composite en couches (2, 21).

3. Transducteur de flexion selon la revendication 1 ou 2, dans lequel les couches céramiques (31, 32) sont composés d'une céramique (315, 325) identique.

4. Transducteur de flexion selon la revendication 1 ou 2, dans lequel les couches céramiques (31, 32) sont composés de céramiques (315, 325) différents.

5. Transducteur de flexion selon l'une des revendications 1 à 4, dans lequel les couches céramiques (31, 32) ont des épaisseurs (314, 324) essentiellementidentiques.

6. Transducteur de flexion selon l'une des revendications 1 à 4, dans lequel les couches céramiques (31 32) ont des épaisseurs (314, 324) différentes.

7. Transducteur de flexion selon l'une des revendications 1 à 6, dans lequel le composite en couches (2, 21) comporte au moins un moyen (23) destiné à réduire une rigidité propre du composite en couches (2).

8. Transducteur de flexion selon la revendication 7, dans lequel le moyen (23) destiné à réduire la rigidité propre est un trou.

9. Transducteur de flexion selon l'une des revendications 1 à 8, dans lequel plusieurs composites monolithiques en couches (2, 21) sont disposés en une pile (7).
